# EUROPEAN PATENT APPLICATION

(11) **EP 0 742 655 A1**
(43) Date of publication of application: **13.11.1996**
(21) Application number: 96106919.2
(22) Date of filing: 02.05.1996
(51) Int. Cl.: H04L 7/027, H03H 9/64, H03H 9/145

(54) **Timing separating circuit having a plurality of filters**

(30) Priority: 10.05.1995 JP 111000/95
(71) Applicant: NEC CORPORATION, Tokyo (JP)
(72) Inventor: Morisaki, Tadahiro, Minato-ku, Tokyo (JP)
(74) Representative: Glawe, Delfs, Moll & Partner

(57) **Abstract**

A timing separating circuit of the present invention has a plurality of SAW (Surface Acoustic Wave) filters each having a particular pass band. The SAW filters are formed on a single piezoelectric substrate and connected in parallel to each other. A differentiator produces a signal to be applied to the SAW filters. An amplifier amplifies a signal separated by any of the SAW filters. A limiter limits the resulting output of the amplifier and shapes it to a desired timing.

## Description

### BACKGROUND OF THE INVENTION

The present invention relates to a timing separating circuit and, more particularly, to a circuit for separating the timing of an input digital signal by use of a SAW (Surface Acoustic Wave) filter formed on a piezoelectric substrate and having electrodes arranged in a cross-finger configuration.

A timing separating circuit of the type described has a differentiator for differentiating an input digital signal from which a timing (clock) should be separated, a bandpass filter to which the output of the differentiator is input, an amplifier for amplifying the output of the filter, and a limiter for limiting the amplitude of the output of the amplifier, as taught in Japanese Patent Laid-Open Publication No. 4-4633 by way of example.

The above filter is implemented by a SAW filter. To separate a timing or clock component from the input digital signal, the SAW filter is provided with a desired bandpass filter characteristic.

To deal with input digital signals having various clock frequencies, it has been customary to use timing separating circuits each having a SAW filter whose bandpass filter characteristic matches one of the clock frequencies.

A transmission rate differs from one digital signal to another digital signal and from one country or zone to another country or zone. This also requires timing separating circuits each having the respective SAW filter whose bandpass filter characteristic matches one of the transmission rates. The problem with such a conventional scheme is that when the transmission rate is changed, the SAW filter in operation must be replaced with another SAW filter matching a new clock frequency. As a result, not only the filter but also the timing separating circuit or even the entire apparatus must be replaced.

Moreover, when circuitry is designed while taking account of the switching between the digital signals, it is necessary to mount a plurality of SAW filters each having a particular bandpass filter characteristic on a circuit board. This not only complicates the circuitry but increases a required mounting area.

### Summary of the Invention

It is therefore an object of the present invention to provide a timing separating circuit capable of dealing with input digital signals of various transmission rates with a simple configuration.

A timing separating circuit of the present invention has a plurality of SAW filters formed on a single piezoelectric substrate and connected in parallel to each other. The SAW filters are constructed into a single package with their input terminals and output terminals respectively connected together. With this arrangement, the circuit is adaptive to input digital signals having a plurality of transmission rates.

The parallel connection of the SAW filters each having a particular bandpass filter characteristic eliminates the need for filter replacement even when the frequency of an input digital signal is changed. In addition, the SAW filters implemented as a single package simplifies the circuit arrangement and reduces the mounting area.

### Brief Description of the Drawings

The above and other objects, features and advantages of the present invention will become apparent from the following detailed description when taken with the accompanying drawings in which:
Fig. 1 is a block diagram schematically showing a timing separating circuit embodying the present invention;
Fig.2 shows a specific arrangement of a filter circuit included in the embodiment;
Fig. 3 shows an equivalent circuit representative of the filter circuit of Fig. 2;
Fig. 4 shows a composite frequency characteristic particular to the filter circuit of Fig. 2;
Fig. 5 is a block diagram schematically showing another embodiment of the present invention;
Fig. 6 shows a specific arrangement of a filter circuit included in the embodiment of Fig. 5;
Fig. 7 shows an equivalent circuit representative of the filter circuit of Fig. 6;
Fig. 8 is a block diagram schematically showing a further embodiment of the present invention;
Fig. 9 shows a specific arrangement of a filter circuit included in the embodiment of Fig. 8; and
Fig. 10 is an equivalent circuit representative of the filter circuit of Fig. 9.

In the figures, the same or similar constituent parts are designated by like reference numerals.

### Detailed Description of the Preferred Embodiments

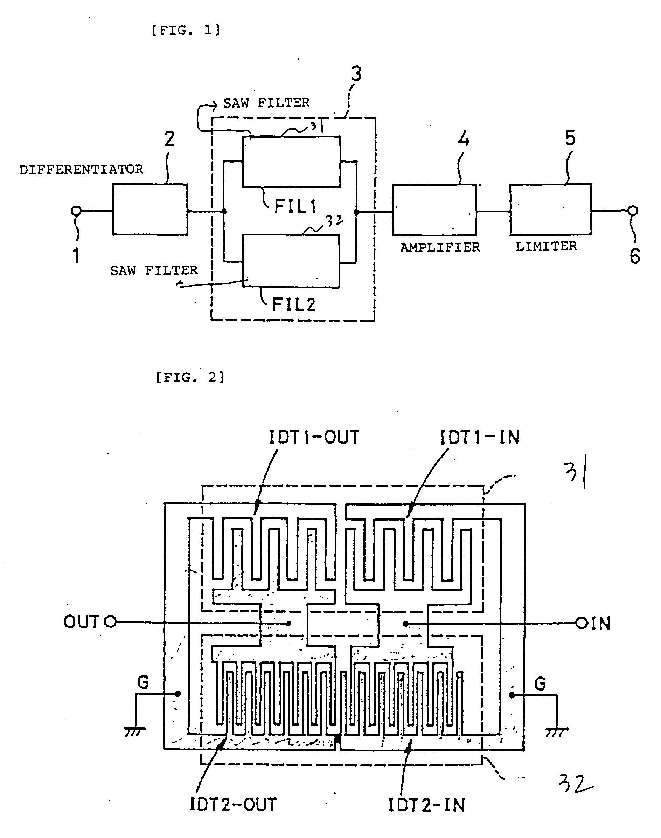

Referring to Fig. 1 of the drawings, a timing separating circuit embodying the present invention is shown. As shown, the circuit has a differentiator 2 to which a digital signal is applied via an input terminal 1. The differentiator 2 differentiates the input signal and delivers the resulting pulse signal to a filter circuit 3. In the illustrative embodiment, the filter circuit 3 has two SAW (Surface Acoustic Wave) filters FIL1 and FIL2 each having a particular pass band center frequency. The filters FIL1 and FIL2 are connected in parallel with their inputs and outputs respectively connected together, as illustrated. The filter circuit 3 outputs a signal having a sinusoidal waveform. The output signal of the filter circuit 3 is amplified by an amplifier 4 and then fed to a limiter 5. The limiter limits the amplitude of the output signal of the amplifier 4 and delivers the resulting clock pulses via an output terminal 6.

In operation, when a digital signal having a certain transmission rate arrives at the input terminal 1, it is passed through the SAW filter FIL1 included in the filter circuit 3. When a digital signal having another transmission rate arrives at the input terminal 1, it is passed through the other SAW filter FIL2.

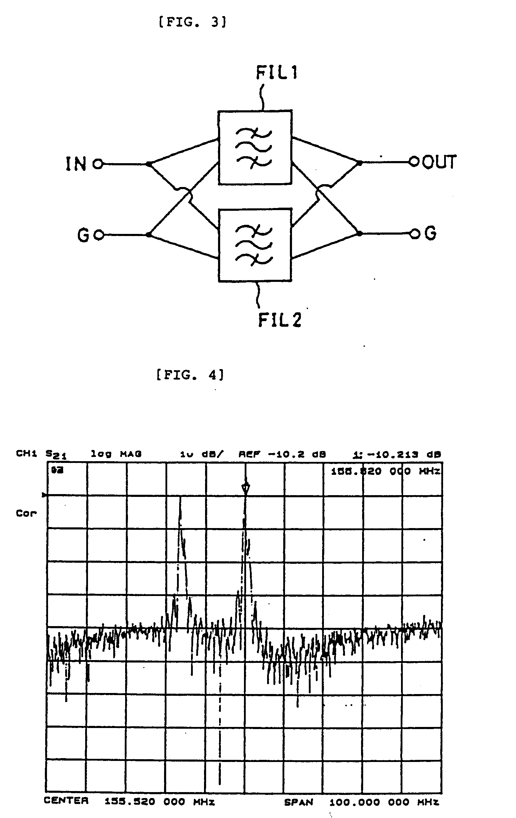

A specific configuration of the filter circuit 3 is shown in Fig. 2. As shown, two SAW filters 31 and 32 (FIL1 and FIL2, Fig. 1) are formed on a common piezoelectric substrate, not shown. The filter 31 has first electrodes IDT1-IN and second electrodes IDT1-OUT each having an cross-finger configuration. Likewise, the filter 32 has first electrodes IDT2-IN and second electrodes IDT2-OUT each having a cross-finger configuration. The first electrodes IDT1-IN and IDT2-IN are connected to a common input terminal IN while the second electrodes IDT1-OUT and IDT2-OUT are connected to a common output terminal OUT. Fig. 3 shows the parallel connection of the two filters FIL1 and FIL2 in an equivalent circuit.

Surface acoustic waves excited by the first electrodes IDT1-IN and IDT2-IN are detected by the second electrodes IDT1-OUT and IDT2-OUT, respectively. The bandpass filter characteristic of each filter FIL1 or FIL2 is determined by the pitch of its electrodes, among others. Fig. 4 shows the composite characteristic of the filters FIL1 and FIL2.

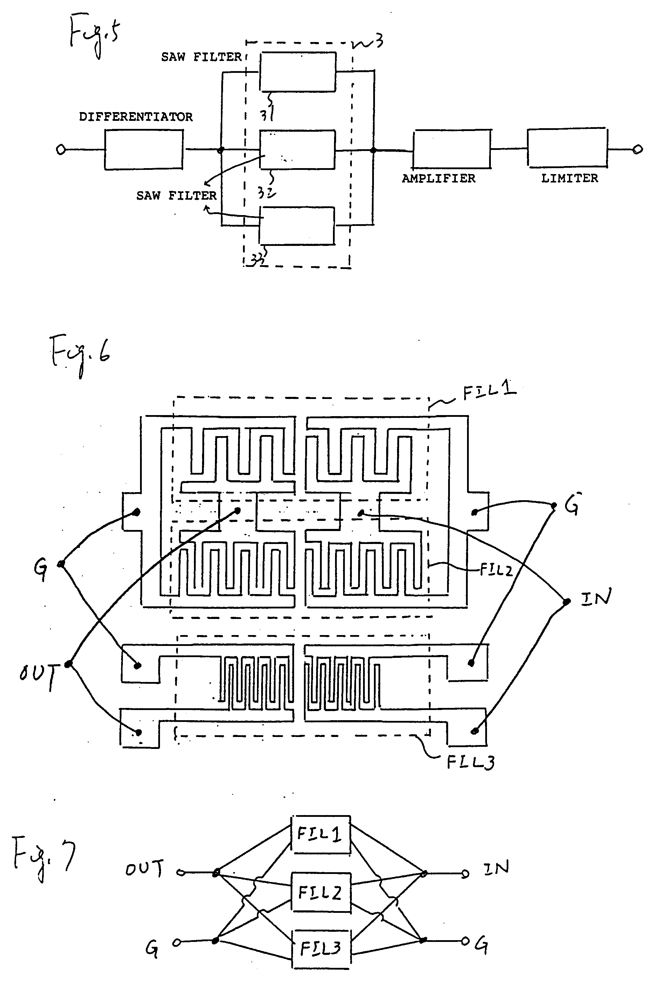

Fig. 5 shows another embodiment of the present invention. As shown, the embodiment has three filters 31, 32 and 33 constituting the filter circuit 3. As shown in Figs. 6 and 7, the filters 31-33, like the filters 31 and 32 of the previous embodiment, are formed on a single substrate and connected in parallel. With this configuration, it is possible to separate the timings of three different frequencies.

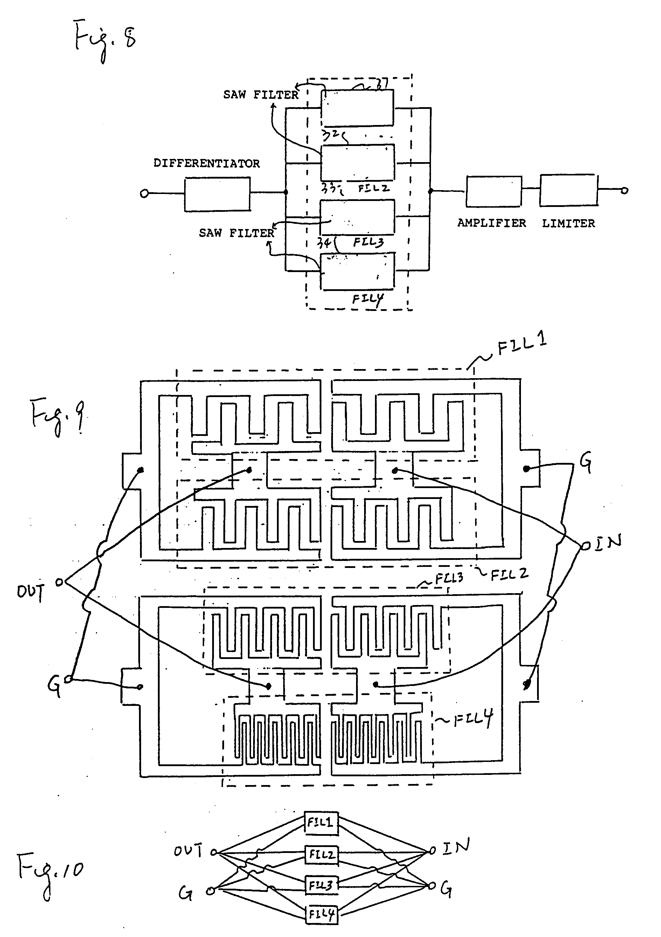

Fig. 8 shows a further embodiment of the present invention. As shown, this embodiment is similar to the previous embodiments except that four filters 31, 32, 33 and-34 are connected in parallel to each other. Specifically, as shown in Figs. 9 and 10, the filters 31-34 are formed on a single substrate and connected in parallel to each other.

## Claims

1. A timing separating circuit for separating a timing of an input digital signal by a SAW filter having electrodes formed on a piezoelectric substrate in a cross-finger configuration, said circuit comprising:
a plurality of SAW filters each having a particular pass band center frequency, wherein said plurality of SAW filters are formed on a single piezoelectric substrate and connected in parallel to each other.

2. A circuit as claimed in claim 1, wherein said plurality of SAW filters each comprises first electrodes and second electrodes each having a cross-finger configuration and formed on said single piezoelectric substrate, wherein said second electrodes detect a surface acoustic wave excited by said first electrodes, and wherein said first electrodes of said plurality of SAW filters are connected to a common input terminal while said second electrodes of said plurality of SAW filters are connected to a common output terminal.

3. A circuit as claimed in claim 2, further comprising:
a differentiator for differentiating the input digital signal and feeding a resulting differentiated output to said common input terminal;
an amplifier for amplifying an output signal to be fed to said common output terminal; and
a limiter for limiting an amplitude of an output signal of said amplifying circuit.

4. A circuit as claimed in claim 1, wherein said plurality of SAW filters comprise two SAW filters.

5. A circuit as claimed in claim 4, wherein said two SAW filters comprise an input transducer comprising a first common ground electrode and two pairs of input electrodes formed symmetrically with respect said first common ground electrode, and an output transducer comprising a second common ground electrode and two pairs of output electrodes formed symmetrically with respect to said second common ground electrode.
